Europäisches Patentamt

European Patent Office

Office européen des brevets

(19)

(11) **EP 1 155 171 B1**

(12) **EUROPÄISCHE PATENTSCHRIFT**

(45) Veröffentlichungstag und Bekanntmachung des Hinweises auf die Patenterteilung:
**07.05.2003 Patentblatt 2003/19**

(21) Anmeldenummer: **00910531.3**

(22) Anmeldetag: **17.02.2000**

(51) Int Cl.$^7$: **C30B 23/00**, C30B 29/36

(86) Internationale Anmeldenummer:
**PCT/DE00/00446**

(87) Internationale Veröffentlichungsnummer:
**WO 00/049207 (24.08.2000 Gazette 2000/34)**

(54) **VERFAHREN ZUM ZÜCHTEN EINES $G(A)-SIC-VOLUMENEINKRISTALLS**

METHOD FOR GROWING AN $G(A)-SIC VOLUME SINGLE CRYSTAL

PROCEDE DE CROISSANCE D'UN MONOCRISTAL VOLUMIQUE DE CARBURE DE SILICIUM ALPHA

(84) Benannte Vertragsstaaten:
**CH DE FR LI SE**

(30) Priorität: **19.02.1999 DE 19907143**

(43) Veröffentlichungstag der Anmeldung:
**21.11.2001 Patentblatt 2001/47**

(73) Patentinhaber: **SIEMENS AKTIENGESELLSCHAFT**
**80333 München (DE)**

(72) Erfinder:
• **STEIN, Rene**
**D-91341 Röttenbach (DE)**
• **VÖLKL, Johannes**
**D-91056 Erlangen (DE)**
• **KUHN, Harald**
**D-91054 Erlangen (DE)**

(56) Entgegenhaltungen:
**EP-A- 0 712 150**          **WO-A-97/27350**
**DE-A- 3 915 053**

• **HEYDEMANN V D ET AL: "Sublimation growth of 4H- and 6H-SiC boule crystals" DIAMOND AND RELATED MATERIALS,NL,ELSEVIER SCIENCE PUBLISHERS, AMSTERDAM, Bd. 6, Nr. 10, 1. August 1997 (1997-08-01), Seiten 1262-1265, XP004096919 ISSN: 0925-9635**

EP 1 155 171 B1

**Beschreibung**

Die Erfindung betrifft ein Verfahren zum Züchten von $\alpha$-SiC-Volumeneinkristallen, bei dem der Volumeneinkristall aus einer SiC-Gasphase durch Abscheiden von SiC an einem SiC-Keimkristall gebildet wird. Unter SiC-Gasphase wird dabei eine Gasphase mit den Komponenten Si, SiC, $Si_2C$ und $SiC_2$ verstanden. $\alpha$-SiC-Volumeneinkristalle umfassen Kristalle mit rhomboedrischer und hexagonaler Struktur.

SiC ist das typische Beispiel einer Substanz, die das Erscheinungsbild des Polytypismus (eindimensionaler Polymorphismus) zeigt. In der Literatur sind über 200 polytype Modifikationen, die hier als Polytypen bezeichnet werden, bekannt. Die Polytypen besitzen unterschiedliche physikalische Eigenschaften, wie Bandabstand, Elektronenbeweglichkeit und optische Eigenschaften. Die bekanntesten Polytypen sind die mit der Bezeichnung 4H, 6H, 3C und 15R. Besonders die drei Polytypen 4H, 6H, und 15R haben offensichtlich im wesentlichen die gleiche Bildungsenthalpie und damit die gleiche thermodynamische Stabilität. Unter diesen drei Polytypen sind 4H und 6H häufiger als der Polytyp 15R. Es ist daher anzunehmen, daß der Polytyp 15R eine etwas geringere thermodynamische Stabilität besitzt als die anderen beiden Polytypen. Zur Herstellung eines 4H- oder 6H-SiC-Volumeneinkristalls sind verschiedene Verfahren bekannt. So wird beispielsweise in der EP 0 712 150 A1 und der WO 97/27350 A1 die Herstellung eines 6H-SiC-Volumeneinkristalls beschrieben, wobei ein 6H-SiC-Keimkristall mit einer Wachstumsoberfläche, deren Normale um 3° bzw. um 5° gegen die [0001]-Kristallrichtung gekippt ist, verwendet wird.

Der Polytyp 15R hat für einige elektronische Anwendungen vorteilhafte Eigenschaften, die ihn für die Herstellung von beispielsweise MOS-Transistoren interessant erscheinen lassen.

Von Chien, F. R., Nutt, S. R., Yoo, W. S., Kimoto, T., Matsunami, H. wird in J. Mater. Res. 9 (1994) 940 beschrieben, daß auf 15R-Substraten 3C-Schichten ohne sogenannte Double Position Boundaries (DPB) aufwachsen. Die reproduzierbare Herstellung von SiC-Volumen-Einkristallen ist jedoch sehr schwierig. Bisher ergaben sich 15R-Einschlüsse in Substratscheiben bei der Herstellung rein zufällig und ließen sich nicht reproduzierbar erzeugen.

Die Erzeugung von 15R-Kristallen mittels Epitaxie ist bisher praktisch nicht möglich, da beim epitaxialen Aufwachsen auf fehlorientiertes Substrat die Epitaxieschichten i.a. dieselbe Modifikation annehmen, die vom Substrat vorgegeben ist. Bei epitaxialem Wachstum auf einem Substrat, das nicht fehlorientiert ist, wächst dagegen vorwiegend die kubische Modifikation, also die 3C-Modifikation. Abgesehen davon sind bei der Epitaxie mit vertretbarem Aufwand nur verhältnismäßig dünne Schichten herstellbar.

Aufgabe der vorliegenden Erfindung ist es, ein Verfahren anzugeben, mit dem SiC-Volumeneinkristalle vom Typ 15R reproduzierbar und ohne Einschränkung des Keimkristalls gezüchtet werden können, so daß die SiC-Volumeneinkristalle als Substrat für ein Halbleiterbauelement (u.U. mit einer nachfolgenden Epitaxieschicht) geeignet sind.

Diese Aufgabe wird gelöst durch das Verfahren mit den Merkmalen nach Anspruch 1. Bevorzugte Ausführungsformen des erfindungsgemäßen Verfahrens sind Gegenstand der abhängigen Unteransprüche.

Der Erfindung liegt die Idee zugrunde, den wachsenden Kristall einer uniaxialen Zugspannung, die eine Komponente in Richtung <11$\bar{2}$0> besitzt, auszusetzen. Dabei bedeutet <11$\bar{2}$0> ein Vektor im Bezugssystem des Kristalls, der in Richtung [11$\bar{2}$0] zeigt, wobei die Ziffern in den spitzen bzw. eckigen Klammern die Indizes sind. Die Verwendung der spitzen Klammern < bzw. > bedeutet, daß alle symmetrisch äquivalenten Vektoren in diesem Kristallsystem-gemeint sind.

Das erfindungsgemäße Verfahren zum Züchten von $\alpha$-SiC-Volumeneinkristallen, bei dem der Volumeneinkristall aus einer SiC-Gasphase durch Abscheiden von SiC auf einem SiC-Keimkristall gebildet wird, ist dadurch gekennzeichnet, daß das Abscheiden unter einer uniaxialen Zugspannung erfolgt, die mit der [0001]-Achse des Volumeneinkristalls einen vorgegebenen Winkel einschließt.

Bei einer ersten bevorzugten Ausführungsform wird die uniaxiale Zugspannung durch ein Temperaturfeld erzeugt, dessen axialer Gradient mit der [0001]-Achse des Volumeneinkristalls den vorgegebenen Winkel einschließt. Weiterhin weist das Temperaturfeld in axialer Richtung eine von Null verschiedene zweite Ortsableitung der Temperatur auf. Es gilt also $d^2T/dx^2 \neq 0$, wobei T für die Temperatur und x für die axiale Ortskoordinate steht. Axial bedeutet hierbei in Wachstumsrichtung, radial steht entsprechend für eine zur Wachstumsrichtung senkrechte Orientierung.

Bei einer weiteren bevorzugten Ausführungsform wird die uniaxiale Zugspannung durch einen Massenstrom von SiC erzeugt, der durch ein Blendensystem in dem vorgegebenen Winkel zu der [0001]-Achse des Volumeneinkristalls auf den Volumeneinkristall gerichtet ist.

Bei einer weiteren bevorzugten Ausführungsform wird die uniaxiale Zugspannung durch Orientieren des Keimkristalls, so daß die Normale einer Wachstumsoberfläche des Keimkristalls mit der [0001]-Achse des Volumeneinkristalls den vorgegebenen Winkel einschließt, erzeugt. Auch hier weist das Temperaturfeld in axialer Richtung eine von Null verschiedene zweite Ortsableitung der Temperatur auf. Es gilt wieder $d^2T/dx^2 \neq 0$. Vorzugsweise ist die Wachstumsoberfläche des Keimkristalls dabei um den vorgegebenen Winkel in eine <11$\bar{2}$0>-Richtung geneigt.

Vorzugsweise beträgt der vorgegebene Winkel zwischen 2° und 10°.

Bei einer weiteren bevorzugten Ausführungsform wird die uniaxiale Zugspannung durch Orientieren des Keimkristalls, so daß die Normale einer Wachstumsoberfläche des Keimkristalls mit der [0001]-Achse des Volumeneinkristalls den vorgegebenen Winkel einschließt, erzeugt. Hier wird zusätzlich zu dieser speziellen Orientierung des Keimkristalls ein inhomogener radialer Temperaturverlauf, also ein radialer Temperaturgradient, eingestellt, so daß sich gekrümmte Isotherme ergeben. Die gekrümmten Isothermen verlaufen dabei im wesentlichen in radialer Richtung. Um die uniaxiale Zugspannung zu erzeugen, ist es insbesondere günstig, wenn die Isothermen einen Krümmungsradius haben, der höchstens 4 mal so groß ist wie der Durchmesser des Volumeneinkristalls.

Bei einer weiteren bevorzugten Ausführungsform wird die uniaxiale Zugspannung dadurch erzeugt, daß der Volumeneinkristall beim Züchten in ein Rohr eingebaut ist, das einen nichtgleichmäßigen Druck auf den wachsenden Kristall ausübt.

Vorzugsweise ist der Keimkristall derart orientiert, daß das Aufwachsen von SiC auf der Seite des Keimkristalls stattfindet, auf der sich die Si-Atome befinden.

Ein Vorteil des erfindungsgemäßen Verfahrens besteht darin, daß sich mit verhältnismäßig geringem Aufwand α-SiC-Volumeneinkristalle, insbesondere vom Typ 15R, reproduzierbar und mit hoher Ausbeute züchten lassen, wobei erstaunlicherweise der Polytyp des eingesetzten Keims keine oder nur eine untergeordnete Rolle spielt.

Weitere Merkmale und Vorteile der Erfindung ergeben sich aus der folgenden Beschreibung eines Ausführungsbeispiels des Verfahrens, wobei Bezug genommen wird auf die beigefügten Zeichnungen.

Fig. 1 zeigt die Orientierung der wesentlichen Achsen beim erfindungsgemäßen Verfahren zum Züchten eines 15R-SiC-Volumeneinkristalls.

Fig. 2A und 2B zeigen jeweils die Anordnung der Atome im Gitter des 6H- bzw. des 15R-SiC-Volumeneinkristalls.

Fig. 3A und 3B zeigt einen Aufbau bzw. den Temperaturverlauf zum Züchten eines Volumeneinkristalls nach dem erfindungsgemäßen Verfahren.

Fig. 4 zeigt Einzelheiten eines Aufbaus zum Züchten des Kristalls nach dem erfindungsgemäßen Verfahren.

Fig. 5 zeigt Einzelheiten eines weiteren Aufbaus zum Züchten des Kristalls nach dem erfindungsgemäßen Verfahren.

Fig. 6 zeigt einen weiteren Aufbau zum Züchten des Kristalls mit einem inhomogenen radialen Temperaturverlauf.

Wenn man den 15R-Polytyp als 6H-Polytyp mit regelmäßig eingebauten Stapelfehlern betrachtet, so ist es prinzipiell möglich aus einem 6H-Kristall durch Verschieben der entsprechenden SiC-Doppellagen in <11$\bar{2}$0> theoretisch einen 15R-Kristall zu konstruieren. Die Stapelfehlerenergie beträgt nur 1,67 kJ/mol (0,4 kcal/mol). Durch die Erfindung wird ein Verfahren angegeben, mit dem ein solcher Stapelfehler praktisch und reproduzierbar erzeugt werden kann. Die kontrollierbare Erzeugung des Stapelfehlers wird dadurch erreicht, daß man den wachsenden Kristall einer uniaxialen Zugspannung mit einer Komponente in Richtung <11$\bar{2}$0>aussetzt. Dazu wird ein fehlorientierter Keimkristall für das Abscheiden des SiC aus der Gasphase verwendet. Durch Einbauen des Keims mit einer Fehlorientierung (= Neigung) zwischen 2° und 10° in eine <11$\bar{2}$0>-Richtung erreicht man, daß ein Temperaturgradient, der in der Sublimationszüchtungsanlage axial, d. h. in Wachstumsrichtung, wirkt, nicht mehr in Richtung der [0001]-Achse wirkt, sondern ein Teil, der durch den Temperaturgradienten erzeugten Spannung parallel zu der (0001)-Gitterebenen wirkt. Dies gilt insbesondere dann, wenn das Temperaturfeld in der Sublimationszüchtungsanlage auch einen Anteil mit von Null verschiedener zweiter Ortsableitung in axialer Richtung ($d^2$T/d$x^2 \neq 0$, mit T = Temperatur and x = axiale Ortskoordinate) aufweist. Dadurch kann ein Einbau von "Zick-Zack-Ketten" bewirkt werden, der nicht mehr symmetrisch ist, so daß anstelle der 6H-Modifikation die 15R-Modifikation entstehen. Die Erzeugung der unsymmetrischen Anordnung der Ketten aus Si- und C-Atomen gelingt jedoch nur, wenn das Wachstum mit der genannten Abweichung von zwischen mindestens 2° bis 10° zu der Richtung der kristallographischen, polaren [000+1]-Richtung erfolgt. Das heißt, die so fehlerorientierte (0001)-Si-Oberfläche des Keims ist die Aufwachsfläche für den zu wachsenden SiC-Volumeneinkristall.

Der Keimkristall kann auch eine Fehlorientierung um den genannten Winkel zwischen 2° und 10° gegen eine von der <11$\bar{2}$0>-Richtung abweichende Kristallorientierung aufweisen. Die Abweichung von der <11$\bar{2}$0>-Richtung kann dabei bis zu 30° betragen.

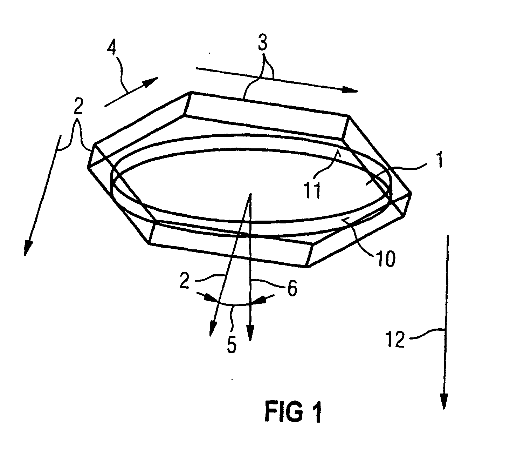

In Fig. 1 ist eine hexagonale Kristallstruktur 1 mit einer Kristallachse gezeigt. Mit 1 ist ein Keimkristall aus SiC bezeichnet. Die Gitterzelle des Keimkristalls 1 ist in symbolischer Darstellung in Fig. 1 gezeigt. Die Grundfläche der Gitterzelle wird durch zwei Vektoren 3 und 4 <11$\bar{2}$0> bzw. <11$\bar{1}$0> aufgespannt. Ein dritter Vektor 2 in der hexagonalen Gitterzelle, der das Volumen der Gitterzelle aufspannt, ist der Vektor [0001]. Er ist mit der Kristallachse des Keimkristalls 1 identisch und schließt in der gezeigten Darstellung einen Winkel 5 mit einer Normalen 6 des Keimkristalls 1 ein. Die Normale 6 des Keimkristalls 1 steh senkrecht auf der Oberfläche des Keimkristalls, auf der sich das SiC zur Bildung des Volumeneinkristalls aus der Gasphase abscheidet. In einer ersten Ausführungsform des erfindungsgemäßen Verfahrens beträgt dieser Winkel 5 zwischen 2° und 10°. (Dabei ist der Winkel 5 der Winkel zwischen der Aufwachsrichtung-und dem [0001]-Vektor 2 des Volumeneinkristalls.)

Mit dem Pfeil 12 ist die Wachstumsrichtung des aufgewachsenen Kristalls angezeigt, die weiter unten näher erläutert wird.

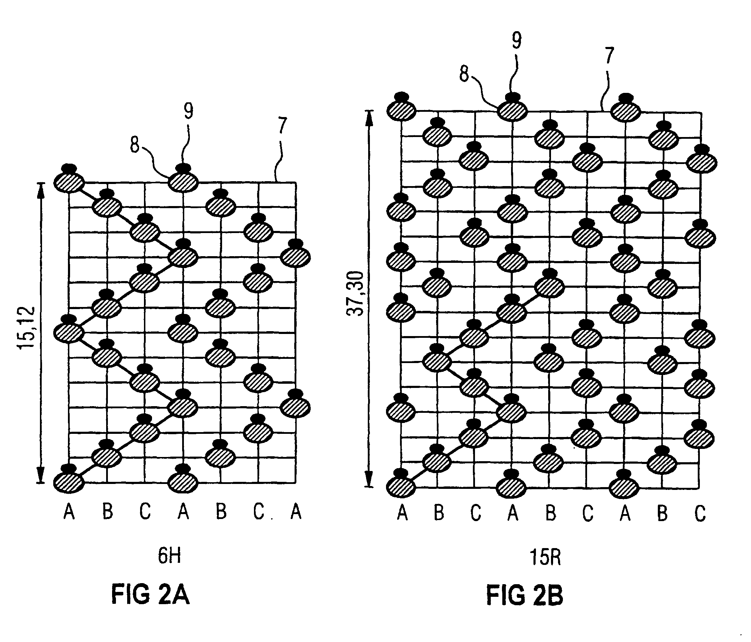

Fig. 2A und 2B zeigt in vereinfachter Darstellung die Anordnung der Atome im Gitter in Richtung des dritten Vektors [0001] der Gitterzelle. Die Atome in dem SiC-Gitter befinden sich in übereinander liegenden Ebenen. Ferner nehmen sie lateral zueinander einen definierten Abstand ein. Dies ist in Fig. 2A und 2B jeweils mit einem Netz aus Hilfslinien 7 dargestellt. Mit kleinen ausgefüllten Kreisen sind die C-Atome 9 angedeutet, mit größeren schattierten Kreisen sind die Si-Atome 8 in dem SiC-Gitter angedeutet.

In Fig. 2A ist die Abfolge der Atome eines SiC-Kristalls mit 6H-Struktur gezeigt. Es ist aus Fig. 2A ersichtlich, daß sich die SiC-Atome nacheinander jeweils um eine Ebene höher und um eine Ebene weiter nach rechts beim Wachstum anordnen. Bei der vierten Ebene kehrt sich die Richtung des lateralen Versatzes um, die nächsten Atome werden nicht mehr rechts versetzt vom vorhergehenden eingebaut, sondern links versetzt davon. Nach wiederum vier Ebenen kehrt sich auch dieser laterale Versatz um. Die Anzahl der Atome, die mit Rechtsversatz in das Gitter eingebaut werden, ist identisch mit der Anzahl der Atome, die mit Linksversatz in das Gitter eingebaut werden, so daß sich eine "Zick-Zack-Kette" mit gleichlangen Gliedern ergibt. Die benachbarten Ebenen sind in Fig. 2A und 2B auf der horizontalen Achse mit A, B, C bezeichnet. Nach sechs Lagen ist ein zum Ausgangspunkt äquivalenter Punkt erreicht. Eine Gitterperiode, d.h. die Strecke von sechs Lagen bis zur ersten Wiederholung hat eine Länge von 1,512 nm (15,12 A).

In Fig. 2B ist die gleiche Situation für ein 15R-Gitter gezeigt. Der Unterschied zwischen der Kristallisierung in 6H und in 15R besteht darin, daß die Anzahl der Ebenen, die mit Rechtsversatz in das Gitter eingebaut werden, bei einem 15R-Kristall um eins größer ist als die Anzahl der Ebenen, die mit Linksversatz in das Gitter eingebaut werden. Die "Zick-Zack-Kette" hat nicht mehr gleichlange Glieder. Daher "wandert" die Kette beim Aufbau nach rechts. Nach sechzehn Lagen ist jedoch auch bei dem 15R-Gitter ein zum Ausgangspunkt äquivalenter Punkt erreicht. Die Gitterperiode beträgt bei der 15R-Kristallisierung 3,73 nm (37,30 A).

Um 15R-SiC zu stabilisieren, ist es besonders günstig, das Wachstum in Richtung der Si-Seite der polaren [0001]-Achse stattfinden zu lassen. Daher ist der Keimkristall 1 derart orientiert, daß auf einer ersten Seite 10 des Keimkristalls 1 die Si-Atome 8 den Abschluß bilden und auf einer zweiten Seite 11 des Keimkristalls 1 die C-Atome 9 den Abschluß bilden. Das Wachstum erfolgt also auf der ersten Seite 10, die sich in der Fig. 2A bzw. Fig. 2B unten befindet: das Wachstum erfolgt mit der Wachstumsrichtung 12 von oben nach unten.

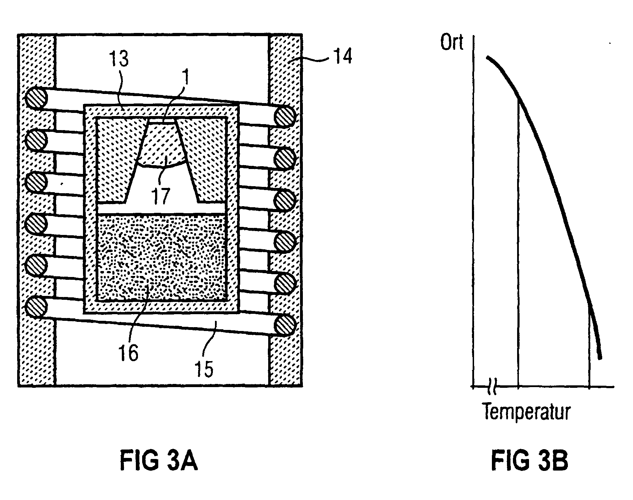

In Fig. 3A und 3B ist eine Vorrichtung für die Durchführung des erfindungsgemäßen Verfahrens bzw. ihr Temperaturverlauf dargestellt. Ein Tiegel 13 ist in einem Ofen 14 angeordnet, der mittels Heizwicklungen bzw. mit Induktionsspulen 15 auf eine durchschnittliche Temperatur von mehr als 2200°C gebracht wird. Der Züchtungstiegel kann insbesondere ein induktiv beheizter Züchtungstiegel sein. In dem Tiegel 13 wird an seinem oberen Ende (am Deckel) der SiC-Keimkristall 1 befestigt. SiC-Pulver 16 an dem unteren Ende des Tiegels 13 wird durch die hohe Temperatur sublimiert und scheidet sich als aufwachsender SiC-Volumeneinkristall 17 an dem Keimkristall 1 ab. Die Temperaturverteilung ist dabei derart, daß eine höhere Temperatur am unteren Ende des Ofens herrscht und eine niedrigere Temperatur am oberen Ende der Ofens herrscht. Dieser Temperaturverlauf ist in Fig. 3B dargestellt, wobei die Temperatur auf der horizontalen Achse und die Höhe im Ofen 14 auf der vertikalen Achse dargestellt ist. Das Temperaturfeld ist praktisch rotationssymmetrisch. Der in Fig. 3B gezeigte Temperaturverlauf weist eine Krümmung und damit einen Anteil mit $d^2T/dx^2 = 0$ auf. Dies trägt maßgeblich zu der für das 15R-Wachstum erforderlichen uniaxialen Zugspannung bei.

Bei der zuletzt genannten Ausführungsform des erfindungsgemäßen Verfahrens wird die uniaxiale Zugspannung außerdem auch durch ein Orientieren des Keimkristalls 1, so daß die Normale der Oberfläche des Keimkristalls 1 einen vorgegebenen Winkel mit der [0001]-Achse 2 des Volumeneinkristalls einschließt, erreicht.

Anstatt den Keimkristall 1 schräg mit dem vorgegebenen Winkel 5 anzuschleifen, kann die uniaxiale Zugspannung auch durch ein rotationssymmetrisches Temperaturfeld erzeugt werden, dessen Symmetrieachse nicht mit der Kristallachse zusammenfällt. In einer weiteren Ausführungsform hat das Temperaturfeld dagegen keine Rotationssymmetrie.

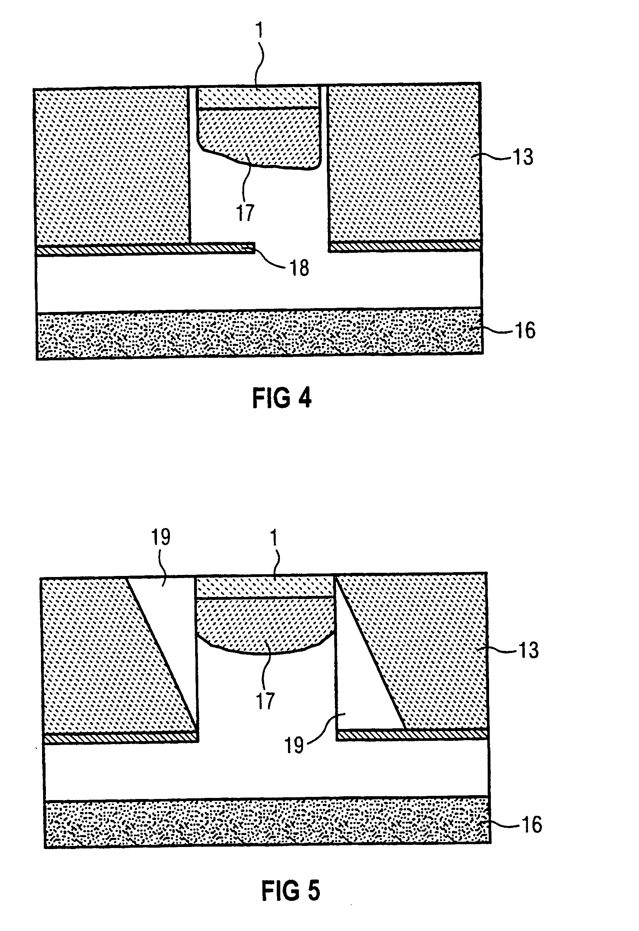

Zusätzlich oder in einer weiteren Ausführungsform des Herstellungsverfahrens kann die uniaxiale Zugspannung durch ein unsymmetrisches Wachsen erzeugt werden. Dies kann beispielsweise dadurch geschehen, daß der Massenstrom der SiC-Gasspezies durch ein Blendensystem in dem Ofen so gelenkt wird, daß der SiC-Volumeneinkristall 17 nach einer vorgegebenen Zeitspanne auf einer Seite weiter gewachsen ist als auf der anderen Seite. Dadurch steht die Normale der Oberfläche der Wachstumsphasengrenze in einem Winkel zu der [0001]-Achse 2 des SiC-Volumeneinkristalls 17. Bei einer gekrümmten Phasengrenze wird hier die gemittelte Oberflächennormale verstanden. Ein derartiges Blendensystem mit einer Blende 18 ist in Fig. 4 gezeigt. Die Blende 18 ist so angeordnet, daß der Massenstrom aus der SiC-Gasphase auf den aufwachsenden SiC-Volumeneinkristall 17 auf einer Seite des SiC-Volumeneinkristalls 17 größer ist als auf der gegenüberliegenden Seite des SiC-Volumeneinkristalls 17: Die Hauptöffnung der Blende 18 ist in Bezug auf die Symmetrieachse des Keimkristalls 1 nicht zentriert angeordnet. Dadurch strömt verdampftes SiC aus dem Vorratsbereich 16 mehr zu der einen Seite des aufwachsenden SiC-Volumeneinkristalls 17, und es wird auf der Seite des SiC-Volumeneinkristalls 17, der der Öffnung der Blende 18 gegenüberliegt, mehr abgeschieden als auf der Seite des SiC-Volumeneinkristalls 17, die "im Schatten" der Blende 18 liegt.

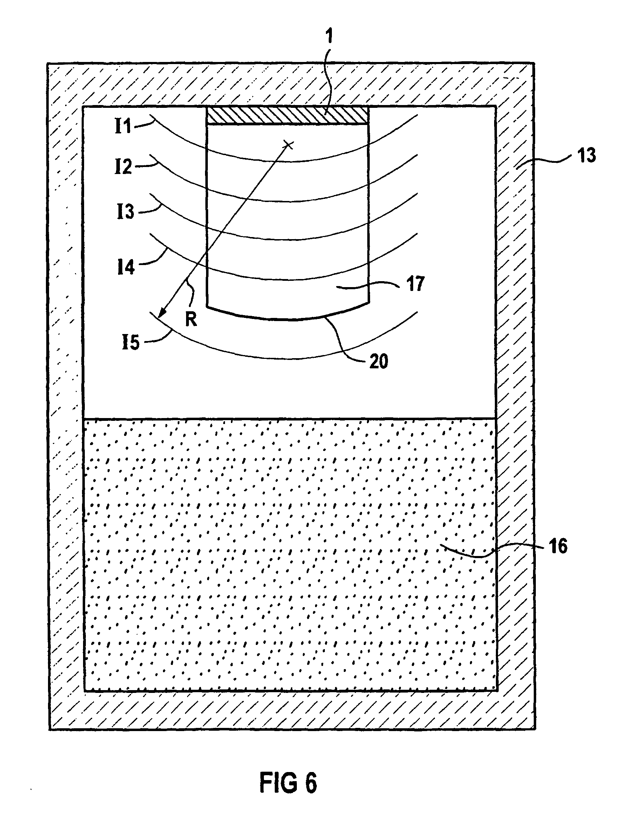

Außerdem kann durch mechanische Vorrichtungen auf den SiC-Volumeneinkristall 17 während des Wachstums eine uniaxiale Zugspannung, deren Resultierende in dem vorgegebenen Winkel 5 wirkt, ausgeübt werden. Eine entsprechende Vorrichtung ist in Fig. 5 gezeigt. Der Keimkristall 1 wird in einem Rohr 19 angeordnet, bei dem die Stärke der Rohrwand von der Höhe und von der Richtung senkrecht zu der Achse des Rohrs 19 abhängt. In der Ausführungsform in Fig. 5 ist z.B. die Stärke der Rohrwand in Höhe des Keimkristalls 1 auf der linken Seite sehr groß, während die gegenüberliegende Wand rechts sehr dünn ist. Dadurch wird erreicht, daß die (nicht dargestellte) Ausdehnung des Rohres 19 aufgrund der hohen Temperatur in dem Ofen auf der Seite der dicken Wand größer ist als bei der dünnen Wand auf der gegenüberliegenden Seite. So wird der SiC-Volumeneinkristall 17 zu einem "schiefen" Wachstum gezwungen. Dabei ist zu beachten, daß sich der Ausdehnungskoeffizient des Materials, aus dem das Rohr 19 hergestellt ist, sich von dem von SiC und auch von dem des umgebenden Tiegels 13 unterscheidet. Damit wird durch den bei der Züchtung herrschenden Temperaturgradienten die besagte Zugspannung auf den SiC-Volumeneinkristall 17 aufgebracht und der SiC-Volumeneinkristall 17 beim Abkühlen einer Scherkraft ausgesetzt, so daß sich die gewünschte asymmetrische "Zick-Zack-Kette" der Atome im SiC-Volumeneinkristall 17 ergibt.

Neben dem oder auch zusätzlich zu dem in Fig. 3B gezeigten axialen Temperaturverlauf, der insbesondere durch eine nicht verschwindende zweite Ortsableitung in axialer Richtung gekennzeichnet ist, kann auch ein inhomogener radialer Temperaturverlauf innerhalb des Tiegels 13 im Zusammenwirken mit einem SiC-Keimkristall 1, dessen Normale gegen die [00013]-Kristallrichtung gekippt ist, eine für die 15R-Züchtung günstige uniaxiale Zugspannung bewirken. Ein solcher vorteilhafter radialer Temperaturverlauf läßt sich am einfachsten durch seine Isotherme beschreiben. In Fig. 6 sind beispielhaft fünf nicht ebene Isotherme I1 bis I5 wiedergegeben, die alle eine Krümmung mit einem Krümmungsradius R aufweisen. Für die Ausbildung einer für ein rhomboedrisches Kristallwachstum ausreichenden uniaxialen Spannung ist die Einstellung eines Temperaturverlaufs mit Isothermen I1 bis I5, deren Krümmungsradius höchstens 4 mal so groß ist wie der Durchmesser des aufwachsenden SiC-Volumeneinkristalls 17, günstig. Im Beispiel von Fig. 6 hat der SiC-Volumeneinkristall 17 einen Durchmesser von etwa 2 Zoll und der Krümmungsradius eine Länge von 180 mm. Bei einem über den Querschnitt des Tiegels 13 homogenen Materialtransport vom Vorrat des SiC-Pulvers 16 zum aufwachsenden SiC-Volumeneinkristall 17 bildet sich der nicht ebene, konvexe Verlauf der Isotherme I1 bis I5 in einer Kristallwachstumsoberfläche 20 ab. Diese hat dann die gleiche Form wie die Isotherme I1 bis I5.

Mit dem erfindungsgemäßen Verfahren wird die Herstellung von α-SiC-Volumeneinkristallen, insbesondere mit rhomboedrischer 15R-Kristallstruktur, für Halbleiterwafer und -substrate möglich. Für einige elektronische Anwendungen, insbesondere MOS-Transistoren, besitzen SiC-Wafer mit 15R-Kristallstruktur besonders vorteilhafte Eigenschaften. In weiteren Verarbeitungsschritten können auf dem 15R-SiC kubische SiC-Epitaxieschichten für elektronische Anwendungen aufgewachsen werden.

**Patentansprüche**

1.   Verfahren zum Züchten eines α-SiC-Volumeneinkristalls, bei dem der Volumeneinkristall aus einer SiC-Gasphase durch Abscheiden von SiC an einem SiC-Keimkristall (1) gebildet wird, **dadurch gekennzeichnet, daß** das Abscheiden unter einer uniaxialen Zugspannung erfolgt, die mit der [0001]-Achse (2) des Volumeneinkristalls einen vorgegebenen Winkel (5) einschließt, so daß ein rhomboedrischer Kristall gebildet wird.

2.   Verfahren nach Anspruch 1, **dadurch gekennzeichnet, daß** die uniaxiale Zugspannung durch ein Temperaturfeld erzeugt wird, dessen axialer Gradient mit der [0001]-Achse (2) des Volumeneinkristalls den vorgegebenen Winkel (5) einschließt und dessen axialer Temperaturverlauf eine von Null verschiedene zweifache Ableitung nach der axialen Ortskoordinate aufweist.

3.   Verfahren nach Anspruch 1 oder 2, **dadurch gekennzeichnet, daß** die uniaxiale Zugspannung durch einen Massenstrom von SiC erzeugt wird, der durch ein Blendensystem (18) in dem vorgegebenen Winkel (5) zu der [0001]-Achse (2) des Volumeneinkristalls auf den Keimkristall (1) gerichtet ist.

4.   Verfahren nach einem der vorangehenden Ansprüche, **dadurch gekennzeichnet, daß** die uniaxiale Zugspannung durch Orientieren des Keimkristalls (1), so daß die Normale einer Wachstumsoberfläche des Keimkristalls (1) mit der [0001]-Achse (2) des Volumeneinkristalls den vorgegebenen Winkel (5) einschließt, erzeugt wird, und ein axialer Temperaturverlauf mit einer von Null verschiedenen zweifachen Ableitung nach der axialen Ortskoordinate eingestellt wird.

5.   Verfahren nach einem der vorangehenden Ansprüche, **dadurch gekennzeichnet, daß** die uniaxiale Zugspannung durch Orientieren des Keimkristalls (1), so daß die Normale einer Wachstumsoberfläche des Keimkristalls (1) mit der [0001]-Achse (2) des Volumeneinkristalls den vorgegebenen Winkel (5) einschließt, erzeugt wird, und ein inhomogener radialer Temperaturverlauf eingestellt wird, der durch gekrümmte Isotherme mit einem Krümmungsradius von höchstens dem 4fachen des Durchmessers des Volumeneinkristalls bestimmt ist.

6. Verfahren nach Anspruch 4 oder 5, **dadurch gekennzeichnet, daß** die uniaxiale Zugspannung durch Orientieren des Keimkristalls (1), so daß die Wachstumsoberfläche des Keimkristalls (1) um den vorgegebenen Winkel (5) in eine <11$\bar{2}$0>-Richtung geneigt ist, erzeugt wird.

7. Verfahren nach einem der vorangehenden Ansprüche, **dadurch gekennzeichnet, daß** die uniaxiale Zugspannung dadurch erzeugt wird, daß der Volumeneinkristall in ein Rohr (19) eingebaut ist, das einen Druck auf den wachsenden Kristall ausübt, der zu einer uniaxialen Zugspannung führt, die den vorgegebenen Winkel (5) mit der [0001]-Achse (2) des Volumeneinkristalls einschließt.

8. Verfahren nach einem der vorangehenden Ansprüche, **dadurch gekennzeichnet, daß** der vorgegebene Winkel (5) zwischen 2° und 10° beträgt.

9. Verfahren nach einem der vorangehenden Ansprüche, **dadurch gekennzeichnet, daß** der Keimkristall (1) derart orientiert ist, daß das Aufwachsen von SiC auf der Seite (10) des Keimkristalls stattfindet, auf der sich die Si-Atome (8) befinden.

## Claims

1. Method for growing an $\alpha$-SiC bulk single crystal, in which the bulk single crystal is formed from an SiC gas phase by deposition of SiC on an SiC seed crystal (1), **characterised in that** the deposition takes place under a uniaxial tensile stress which includes a predetermined angle (5) with the [0001] axis (2) of the bulk single crystal, so that a rhombohedral crystal is formed.

2. Method according to Claim 1, **characterised in that** the uniaxial tensile stress is generated by a temperature field, the axial gradient of which includes the predetermined angle (5) with the [0001] axis (2) of the bulk single crystal and the axial temperature profile of which has a non-vanishing double derivative towards the axial spatial coordinate.

3. Method according to Claim 1 or 2, **characterised in that** the uniaxial tensile stress is generated by a mass flow of SiC which, by means of a diaphragm, system (18), is directed onto the seed crystal (1) at the predetermined angle (5) with respect to the [0001] axis (2) of the bulk single crystal.

4. Method according to one of the preceding claims, **characterised in that** the uniaxial tensile stress is generated by orientation of the seed crystal (1) so that the normal to a growth surface of the seed crystal (1) includes the predetermined angle (5) with the [0001] axis (2) of the bulk single crystal, and an axial temperature profile with a non-vanishing double derivative towards the axial spatial coordinate is established.

5. Method according to one of the preceding claims, **characterised in that** the uniaxial tensile stress is generated by orientation of the seed crystal (1) so that the normal to a growth surface of the seed crystal (1) includes the predetermined angle (5) with the [0001] axis (2) of the bulk single crystal, and an inhomogeneous radial temperature profile is established, which is determined by curved isotherms with a radius of curvature of at most 4 times the diameter of the bulk single crystal.

6. Method according to Claims 4 or 5, **characterised in that** the uniaxial tensile stress is generated by orientation of the seed crystal (1) so that the growth surface of the seed crystal (1) is inclined in a <11$\bar{2}$0> direction by the predetermined angle (5).

7. Method according to one of the preceding claims, **characterised in that** the uniaxial tensile stress is generated as a result of the bulk single crystal being fitted into a tube (19) which exerts a pressure on the growing crystal, leading to a uniaxial tensile stress which includes the predetermined angle (5) with the [0001] axis (2) of the bulk single crystal.

8. Method according to one of the preceding claims, **characterised in that** the predetermined angle (5) is between 2° and 10°.

9. Method according to one of the preceding claims, **characterised in that** the seed crystal (1) is orientated in such a manner that the growth of SiC takes place on that side (10) of the seed crystal on which the Si atoms (8) are situated.

## Revendications

1. Procédé de croissance d'un monocristal volumique de carbure de silicium alpha, dans lequel on forme le monocristal volumique à partir d'une phase gazeuse de SiC par dépôt de SiC sur un cristal (1) germe en SiC, **caractérisé en ce que** l'on effectue le dépôt sous une contrainte de traction uniaxiale qui fait, avec l'axe (2) [0001] du monocristal volumique, un angle (5) prescrit, de manière à former un cristal rhomboédrique.

2. Procédé suivant la revendication 1, **caractérisé en ce que** l'on produit la contrainte de traction uniaxiale par un champ de température dont le gradient axial fait, avec l'axe (2) [0001] du monocristal volumique, l'angle (5) prescrit et dont la courbe axiale de température a une dérivée seconde différente de zéro en fonction de la coordonnée spatiale axiale.

3. Procédé suivant la revendication 1 ou 2, **caractérisé en ce que** l'on produit la contrainte de traction uniaxiale par un courant massique de SiC qui est dirigé sur le cristal (1) germe par un système (18) d'écran en faisant l'angle (5) prescrit avec l'axe (2) [0001] du monocristal volumique.

4. Procédé suivant l'une des revendications précédentes, **caractérisé en ce que** l'on produit la contrainte de traction uniaxiale en orientant le cristal (1) germe de sorte que la normale à une surface de croissance du cristal (1) germe fasse l'angle prescrit avec l'axe (2) [0001] du monocristal volumique, et en établissant une courbe axiale de température ayant une dérivée seconde différente de zéro en fonction de la coordonnée spatiale axiale.

5. Procédé suivant l'une des revendications précédentes, **caractérisé en ce que** l'on produit la contrainte de traction uniaxiale en orientant le cristal (1) germe de sorte que la normale à une surface de croissance du cristal (1) germe fasse l'angle prescrit avec l'axe (2) [0001] du monocristal volumique, et en établissant une courbe de température radiale non homogène qui est déterminée par des isothermes courbés ayant un rayon de courbure représentant au plus quatre fois le diamètre du monocristal volumique.

6. Procédé suivant la revendication 4 ou 5, **caractérisé en ce que** l'on produit la contrainte de traction uniaxiale en orientant le cristal (1) germe de sorte que la surface de croissance du cristal (1) germe soit inclinée de l'angle (5) prescrit dans une direction <11$\bar{2}$0>.

7. Procédé suivant l'une des revendications précédentes, **caractérisé en ce qu'**on produit la contrainte de traction uniaxiale en insérant le monocristal volumique dans un tube (19) qui applique au cristal en croissance une pression qui donne une contrainte de traction uniaxiale formant l'angle (5) prescrit avec l'axe (2) [0001] du monocristal volumique.

8. Procédé suivant l'une des revendications précédentes, **caractérisé en ce que** l'angle (5) prescrit est compris entre 2° et 10°.

9. Procédé suivant l'une des revendications précédentes, **caractérisé en ce que** l'on oriente le cristal (1) germe de façon à ce que la croissance de SiC ait lieu du côté (10) du cristal germe sur lequel se trouvent les atomes (8) de Si.

FIG 1

6H

**FIG 2A**

15R

**FIG 2B**

FIG 3A

FIG 3B

**FIG 4**

**FIG 5**

EP 1 155 171 B1

FIG 6